(19) **Europäisches Patentamt**
**European Patent Office**
**Office européen des brevets**

(11) **EP 3 629 036 B1**

(12) **EUROPÄISCHE PATENTSCHRIFT**

(45) Veröffentlichungstag und Bekanntmachung des Hinweises auf die Patenterteilung:
**16.08.2023  Patentblatt 2023/33**

(51) Internationale Patentklassifikation (IPC):
**G01R 31/58** (2020.01)       **G01R 31/11** (2006.01)

(21) Anmeldenummer: **18197242.3**

(52) Gemeinsame Patentklassifikation (CPC):
**G01R 31/11; G01R 31/58**

(22) Anmeldetag: **27.09.2018**

(54) **VERFAHREN ZUR BESTIMMUNG VON REFLEXIONEN AUF EINER LEITUNG**

METHOD FOR DETERMINING REFLECTIONS ON A LINE

PROCÉDÉ DE DÉTERMINATION DES RÉFLEXIONS SUR UNE LIGNE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.04.2020  Patentblatt 2020/14**

(73) Patentinhaber: **Siemens Aktiengesellschaft 80333 München (DE)**

(72) Erfinder: **Frankenberg, Robert 1210 Wien (AT)**

(74) Vertreter: **Siemens Patent Attorneys Postfach 22 16 34 80506 München (DE)**

(56) Entgegenhaltungen:
CN-A- 107 576 890       DE-A1-102009 014 781
US-A1- 2003 035 376       US-A1- 2004 073 395

**Beschreibung**

Die Erfindung betrifft ein Verfahren zur Bestimmung von Reflexionen auf einer Leitung gemäß Anspruch 1.

Die Erfindung betrifft ferner eine Vorrichtung zur Bestimmung von Reflexionen auf einer Leitung gemäß Anspruch 10, welche einen Impulsgenerator, einen Sender, einen Empfänger und eine Analysevorrichtung umfasst, wobei die Vorrichtung dazu eingerichtet ist, durch den Impulsgenerator einen Impuls zu erzeugen und mittels des Senders in eine Leitung einzuspeisen, sowie von dem Empfänger von der Leitung eine auf den Impuls folgende Impulsantwort zu empfangen und von der Analysevorrichtung weiter zu verarbeiten.

Niederspannungsnetze altern im Laufe der Zeit und können dabei störungsanfällig werden, was zu unerwünschten Ausfällen in der Versorgung der Verbraucher, als auch zu kostenintensiven Wartungs- und Reparaturarbeiten der Netzleitungen führen kann. Dies gilt auch für andere Arten von elektrischen oder optischen Leitungen, beispielsweise Telefon-, Telekommunikations- oder Fernwirkleitungen.

Es ist oft schwierig im Zuge von Wartungsarbeiten zukünftige Störungen oder Ausfälle des Netzes zu erkennen, um beispielsweise präventiv einen Austausch einer Komponente, die auszufallen droht, durchzuführen. Mit anderen Worten kann es nachteilig sein, wenn ein Ausfall, insbesondere die Art und der Ort des Ausfalls, nur sehr schwer prognostiziert werden kann. Ein unbegründeter, präventiv vorgenommener Austausch von Komponenten ist in den meisten Fällen wirtschaftlich nicht sinnvoll.

Ferner ist es häufig nötig und nachteilig, dass ein Verbraucher eine Störung beziehungsweise einen Ausfall des Netzes beispielsweise telefonisch meldet, bevor eine entsprechende Reparatur begonnen werden kann. Dadurch kann sich die Ausfallzeit unerwünscht weiter vergrößern.

Die bekannten Messverfahren zur Bestimmung von Reflexionen auf einer Leitung werden häufig bei dezidierten Frequenzen sehr ungünstig beeinflusst, sodass der Signal-zu-Rausch-Abstand stark abnimmt und die Messung folglich nicht sehr robust gegen einzelne Störquellen ist.

In der US 2003/035376 A1 ist ein Verfahren offenbart, in welchem eine Impulsantwort auf eine einfache Weise geschätzt wird, indem nur Daten aus einem sehr engen Bereich um eine Reflexionsstelle berücksichtigt werden.

Aus der DE 10 2009 014781 A1 ist ein Verfahren zum Testen eines fehlerhaften Stromkabels im Zeitbereich bekannt, wobei eine Filterfunktion mit der Leitungsadmittanz angewendet wird, um Kenndaten des Kabels zu bestimmen.

Es ist eine Aufgabe der Erfindung, die genannten Nachteile zu überwinden.

Die Aufgabe wird durch ein Verfahren der eingangs genannten Art gelöst, indem folgende Schritte ausgeführt werden:

a) Erzeugen eines elektrischen Impulses und Einspeisen in die Leitung.

b) Erfassen einer Impulsantwort des elektrischen Impulses von der Leitung mit einer Bandbreite.

c) Bilden eines Impulsvektors durch Konvertieren der Impulsantwort in jeweilige Elemente des Impulsvektors in Form komplexer Funktionswerte bei festgelegten Stützstellen im Frequenzbereich.

d) Zuordnen der Stützstellen in

Signalbereiche, an deren Stützstellen das jeweilige Element des Impulsvektors für das entsprechende Element in einen Schätzvektor übernommen wird, wobei die Menge aller Elemente mit Stützstellen in Signalbereichen als Signale bezeichnet werden, sowie

zumindest einen Lückenbereich, an dessen zumindest einer Stützstelle ein vordefinierter Initialwert für das entsprechende Element des Schätzvektors übernommen wird, wobei die Menge aller Elemente mit Stützstellen in dem zumindest einen Lückenbereich als Lücken bezeichnet werden.

e) Bilden eines Fenstervektors auf Basis einer Fensterfunktion durch Diskretisieren an den Stützstellen.

f) Kopieren der Elemente des Schätzvektors in einen Hilfsvektor.

g) Festlegen eines ganzzahligen Koeffizienten.

h) Durchführen von Iterationsschritten zur Bestimmung von Schätzwerten für alle Lücken, und solange Wiederholen, bis eine vordefinierte Anzahl an Iterationen erreicht ist, und bei jeder Iteration folgende Schritte ausgeführt werden:

h1) Ermitteln eines Zeitvektors mit Elementen im Zeitbereich auf Basis des Zusammenhangs

$$x = |iFFT(R * W)|$$

wobei

x     der Zeitvektor mit Elementen im Zeitbereich,
R     der Hilfsvektor mit Elementen im Frequenzbereich, und
W     der Fenstervektor mit Elementen im Frequenzbereich ist,

und der Fenstervektor und der Hilfsvektor jeweils alle Elemente an allen Stützstellen enthalten.

h2) Bestimmen des Maximums der Elemente des Zeitvektors und Ermitteln eines entsprechenden Indexwerts des Maximums innerhalb der Elemente des Zeitvektors.

h3) Berechnen eines Schätzwerts auf Basis des Zusammenhangs

$$Q = \frac{1}{\sum_{\forall j \in Signale} W_j} * \sum_j R_j * W_j * e^{\frac{i*2*\pi*k*j}{N}}$$

wobei

$j$     eine Indexposition,
$Q$     ein Schätzwert der aktuellen Iteration,
$R_j$     das Element des Hilfsvektors an der Indexposition,
$W_j$     das Element des Fenstervektors an der Indexposition,
$Signale$     die Menge aller Elemente an Stützstellen in Signalbereichen, und
$k$     der im Schritt h2) ermittelte Indexwert des Maximums ist, und
$N$     der im Schritt g) festgelegte ganzzahlige Koeffizient ist.

h4) Neuberechnen des Hilfsvektors für die Signale auf Basis des Zusammenhangs

$$R_j = R_j - Q * e^{\frac{i*2\pi*k*j}{N}} \qquad \forall j \in Signale$$

wobei

$j$     eine Indexposition,
$R_j$     das Element des Hilfsvektors an der Indexposition,
$Q$     ein Schätzwert der aktuellen Iteration,
$k$     der im Schritt h2) ermittelte Indexwert des Maximums ist,
$Signale$     die Menge aller Elemente an Stützstellen in Signalbereichen ist, und
$N$     der im Schritt g) festgelegte ganzzahlige Koeffizient ist.

h5) Neuberechnung des Schätzvektors für die Lücken auf Basis des Zusammenhangs

$$X_j = X_j + Q * e^{\frac{i*2\pi*k*j}{N}} \qquad \forall j \in Lücken$$

wobei

$j$     eine Indexposition,
$X_j$     ein Element des Schätzvektors an der Indexposition,
$Q$     ein Schätzwert der aktuellen Iteration,
$k$     der im Schritt h2) ermittelte Indexwert des Maximums ist,

*Lücken* die Menge aller Elemente an Stützstellen im zumindest einen Lückenbereich ist, und

*N* der im Schritt g) festgelegte ganzzahlige Koeffizient ist.

i) Transformieren des Schätzvektors in den Zeitbereich zu einem Zeitsignal.

j) Identifizieren von Reflexionenstellen auf der Leitung in dem Zeitsignal.

Durch das erfindungsgemäße Verfahren wird erreicht, dass Lücken im Frequenzbereich einer erfassten Impulsantwort geschätzt beziehungsweise interpoliert werden und dadurch die weitere Signalauswertung und die Bestimmung von Reflexionen auf einer Leitung mit einer höheren Genauigkeit erfolgen kann. Lücken in der Übertragungsfunktion der Impulsantwort können entstehen oder erzeugt werden, wenn bestimmte Frequenzen in der Impulsantwort einer Leitung fehlerhaft erfasst wurden oder gezielt unterdrückt beziehungsweise ausgeblendet werden, da dort beispielsweise bekannte Störquellen unerwünschte beziehungsweise starke Signale erzeugen.

Der erfindungsgemäße Effekt kann in verbesserter Weise erreicht werden, wenn im Schritt b) der zumindest eine Lückenbereich zwischen Signalbereichen gelegen ist.

Die Erfindung kann weiterentwickelt werden, indem die Impulsantwort des elektrischen Impulses eine Bandbreite aufweist, und im Schritt g) der ganzzahlige Koeffizient durch den Quotienten aus der Bandbreite und dem Abstand zweier unmittelbar aneinandergrenzender Stützstellen bestimmt ist. Dadurch kann ein besonders gutes Ergebnis für die Schätzung erreicht werden.

Die Erfindung kann weiterentwickelt werden, indem im Schritt d) der jeweilige Initialwert zu Null gesetzt ist. Dadurch kann die Iteration besonders effizient durchgeführt werden und somit ein besonders gutes Ergebnis für die Schätzung erreicht werden.

Die Erfindung kann weiterentwickelt werden, indem die Fensterfunktion eine Kosinus- oder eine Kosinus-Roll-Off-Funktion ist und die Fensterfunktion symmetrisch um 0 Hz verläuft. Dadurch kann ein besonders gutes Ergebnis für die Schätzung erreicht werden.

Die Erfindung kann weiterentwickelt werden, indem die Fensterfunktion eine Kosinus- oder eine Kosinus-Roll-Off-Funktion ist und bei 0 Hz den Wert Null aufweist. Dadurch kann ein besonders gutes Ergebnis für die Schätzung erreicht werden.

Die Erfindung kann weiterentwickelt werden, indem ein weiterer Verfahrensschritt folgt:

k) Bestimmen des Zustandes der Leitung aus der Lage und Art der Reflexionsstellen auf der Leitung im Zeitsignal.

Dadurch kann aus der Schätzung der Zustand der Leitung auf einfache Weise bestimmt werden.

Die Erfindung kann weiterentwickelt werden, indem die Art der Reflexionsstellen auf der Leitung durch den Betrag einer Phasenänderung in der Impulsantwort an der Reflexionsstelle den Zustand der Leitung zumindest an der Reflexionsstelle angibt. Dadurch kann der Zustand der Leitung auf einfache Weise noch besser und detailreicher bestimmt werden.

Die erfindungsgemäße Aufgabe wird auch durch eine Vorrichtung der eingangs genannten Art gelöst, indem die Analysevorrichtung dazu eingerichtet ist, das erfindungsgemäße Verfahren auszuführen.

Durch die erfindungsgemäße Vorrichtung wird analog zum erfindungsgemäßen Verfahren erreicht, dass Lücken im Frequenzbereich einer erfassten Impulsantwort geschätzt werden und dadurch die weitere Signalauswertung genauer erfolgen kann. Lücken können entstehen, falls bestimmte Frequenzen in der Impulsantwort einer Leitung fehlerhaft erfasst wurden oder gezielt unterdrückt werden sollen.

Die Erfindung kann weiterentwickelt werden, indem die Leitung eine Netzleitung eines Nieder-, Mittel- oder Hochspannungsnetzes ist und die Analysevorrichtung dazu eingerichtet ist, das erfindungsgemäße Verfahren auszuführen und den Zustand der Netzleitung zu bestimmen. Dadurch kann der Zustand von Netzleitung eines Energieversorgungsnetzes auf einfache Weise bestimmt werden.

Die Erfindung kann weiterentwickelt werden, indem die Vorrichtung von einem Smartmeter umfasst ist. Dadurch kann der Zustand von Netzleitungen eines Energieversorgungsnetzes auf einfache Weise bestimmt werden, welche häufig bereits über Smartmeter verfügen.

Die Erfindung wird nachfolgend anhand von in den beigeschlossenen Zeichnungen dargestellten Ausführungsbeispielen näher erläutert. In den Zeichnungen zeigt:

Fig. 1 eine schematische Darstellung einer Messanordnung zur Bestimmung einer Impulsantwort einer Netzleitung gemäß der Erfindung,

Fig. 2-3 Ablaufdiagramme eines Ausführungsbeispiels des erfindungsgemäßen Verfahrens,

Fig. 4 ein Ausführungsbeispiel für eine Impulsantwort im Frequenzbereich,

Fig. 5 Ausführungsbeispiele einer ersten, einer zweiten und einer dritten Fensterfunktion,

Fig. 6 verschiedene Repräsentationen im Zusammenhang mit der Impulsantwort nach Fig. 4 mit der ersten Fensterfunktion,

Fig. 7        die interpolierte Impulsantwort nach Fig. 6 im Zeitbereich,

Fig. 8        verschiedene Repräsentationen im Zusammenhang mit der Impulsantwort nach Fig. 4 mit der zweiten Fensterfunktion,

Fig. 9        die interpolierte Impulsantwort nach Fig. 8 im Zeitbereich,

Fig. 10       verschiedene Repräsentationen im Zusammenhang mit der Impulsantwort nach Fig. 4 mit der dritten Fensterfunktion,

Fig. 11       die interpolierte Impulsantwort nach Fig. 10 im Zeitbereich.

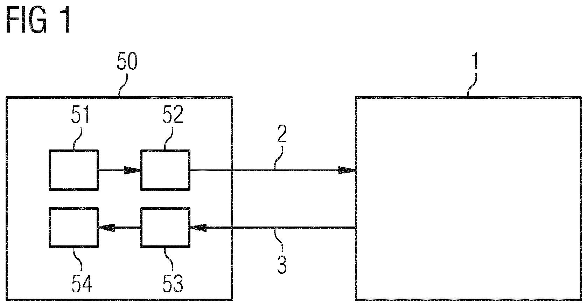

In Fig. 1 ist schematisch eine Messanordnung mit einer Vorrichtung 50 gezeigt. Die Vorrichtung 50 umfasst einen Impulsgenerator 51, einen Sender 52, einen Empfänger 53 und eine Analysevorrichtung 54.

Der Impulsgenerator 51 ist dazu eingerichtet, einen Impuls 2 zu erzeugen und der nachfolgende Sender 52 ist dazu eingerichtet, den erzeugten Puls 2 in eine Netzleitung 1 einzuspeisen.

Der Empfänger 53 ist dazu eingerichtet, von der Netzleitung 1 eine auf den Impuls 2 folgende Impulsantwort 3 innerhalb einer Frequenz-Bandbreite 4 zu empfangen und zu erfassen.

Anschließend ist die Analysevorrichtung 54 dazu eingerichtet, mit der erfassten Impulsantwort 3 das erfindungsgemäße Verfahren auszuführen und Reflexionen auf einer Netzleitung 1 zu bestimmen.

Ferner ist die Vorrichtung dazu eingerichtet, den Netzzustand der Netzleitung 1 zu bestimmen, indem ein entsprechender weiterer Verfahrensschritt ausgeführt wird, auf den nachfolgend näher eingegangen wird.

Die Vorrichtung 50, welche ein Smartmeter sein kann, umfasst die gezeigten Teile, wobei klar ist, dass die Vorrichtung 50 noch weitere wichtige Teile beinhaltet, die eine Ausführung des erfindungsgemäßen Verfahrens ermöglichen, wie beispielsweise analoge oder digitale Filter, eine digitale Datenerfassungseinheit, eine Recheneinheit oder ein Rechenspeicher. Zur besseren Übersichtlichkeit und für ein besseres Verständnis sind diese Teile jedoch nicht dargestellt.

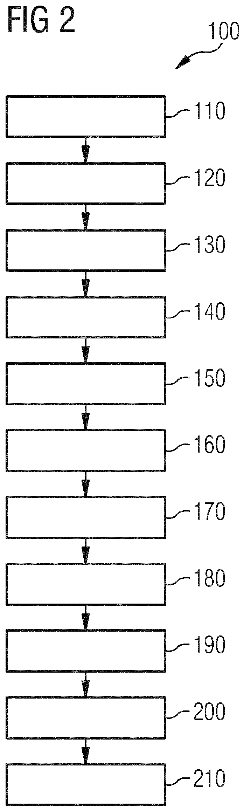

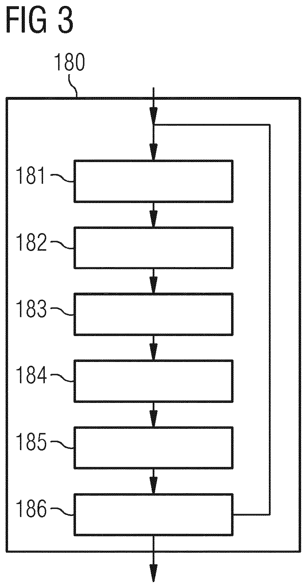

Fig. 2 und 3 zeigen Ablaufdiagramme eines Ausführungsbeispiels des erfindungsgemäßen Verfahrens, welche folgende Schritte umfassen:

a) Erzeugen 110 eines elektrischen Impulses 2 und Einspeisen in die Leitung 1.

b) Erfassen 120 einer Impulsantwort 3 des elektrischen Impulses 2 von der Leitung 1 mit einer Bandbreite 4.

c) Bilden 130 eines Impulsvektors durch Konvertieren der Impulsantwort 3 in jeweilige Elemente des Impulsvektors in Form komplexer Funktionswerte bei festgelegten Stützstellen im Frequenzbereich.

d) Zuordnen 140 der Stützstellen in

Signalbereiche 5-7, an deren Stützstellen das jeweilige Element des Impulsvektors für das entsprechende Element in einen Schätzvektor übernommen wird, wobei die Menge aller Elemente mit Stützstellen in Signalbereichen 5-7 als Signale bezeichnet werden, sowie

Lückenbereiche 8, 9, an deren Stützstellen jeweils ein vordefinierter Initialwert für das entsprechende Element des Schätzvektors übernommen wird, wobei die Menge aller Elemente mit Stützstellen in den Lückenbereichen 8, 9 als Lücken bezeichnet werden.

Die Lückenbereiche 8, 9 sind zwischen den Signalbereichen 5-7 gelegen, und der jeweilige Initialwert beträgt Null.

e) Bilden 150 eines Fenstervektors auf Basis einer Fensterfunktion 10, 20, 30 durch Diskretisieren an den Stützstellen.

f) Kopieren 160 der Elemente des Schätzvektors in einen Hilfsvektor.

g) Festlegen 170 eines ganzzahligen Koeffizienten, welcher durch den Quotienten aus der Bandbreite 4 und dem Abstand zweier unmittelbar aneinandergrenzender Stützstellen bestimmt ist.

h) Durchführen 180 von Iterationsschritten zur Bestimmung von Schätzwerten für alle Lücken, und solange Wiederholen, bis eine vordefinierte Anzahl an Iterationen erreicht ist, und bei jeder Iteration folgende Schritte ausgeführt werden:

h1) Ermitteln 181 eines Zeitvektors mit Elementen im Zeitbereich auf Basis des Zusammenhangs

$$x = |iFFT(R * W)|$$

wobei

$x$     der Zeitvektor mit Elementen im Zeitbereich,
$R$     der Hilfsvektor mit Elementen im Frequenzbereich, und
$W$     der Fenstervektor mit Elementen im Frequenzbereich ist,

und der Fenstervektor und der Hilfsvektor jeweils alle Elemente an allen Stützstellen enthalten.

h2) Bestimmen 182 des Maximums der Elemente des Zeitvektors und Ermitteln eines entsprechenden Indexwerts des Maximums innerhalb der Elemente des Zeitvektors.

h3) Berechnen 183 eines Schätzwerts auf Basis des Zusammenhangs

$$Q = \frac{1}{\sum_{\forall j \in Signale} W_j} * \sum_j R_j * W_j * e^{\frac{i*2*\pi*k*j}{N}}$$

wobei

$j$     eine Indexposition,
$Q$     ein Schätzwert der aktuellen Iteration,
$R_j$     das Element des Hilfsvektors an der Indexposition,
$W_j$     das Element des Fenstervektors an der Indexposition,
$Signale$     die Menge aller Elemente an Stützstellen in Signalbereichen 5-7, und
$k$     der im Schritt h2) ermittelte Indexwert des Maximums ist, und
$N$     der im Schritt g) festgelegte ganzzahlige Koeffizient ist.

h4) Neuberechnen 184 des Hilfsvektors für die Signale auf Basis des Zusammenhangs

$$R_j = R_j - Q * e^{\frac{i*2\pi*k*j}{N}} \qquad \forall j \in Signale$$

wobei

$j$     eine Indexposition,
$R_j$     das Element des Hilfsvektors an der Indexposition,
$Q$     ein Schätzwert der aktuellen Iteration,
$k$     der im Schritt h2) ermittelte Indexwert des Maximums ist,
$Signale$     die Menge aller Elemente an Stützstellen in Signalbereichen 5-7 ist, und
$N$     der im Schritt g) festgelegte ganzzahlige Koeffizient ist.

h5) Neuberechnung 185 des Schätzvektors für die Lücken auf Basis des Zusammenhangs

$$X_j = X_j + Q * e^{\frac{i*2\pi*k*j}{N}} \qquad \forall j \in Lücken$$

wobei

$j$     eine Indexposition,
$X_j$     ein Element des Schätzvektors an der Indexposition,

| | |
|---|---|
| Q | ein Schätzwert der aktuellen Iteration, |
| k | der im Schritt h2) ermittelte Indexwert des Maximums ist, |
| Lücken | die Menge aller Elemente an Stützstellen in Lückenbereichen 8, 9 ist, und |
| N | der im Schritt g) festgelegte ganzzahlige Koeffizient ist. |

i) Transformieren 190 des Schätzvektors in den Zeitbereich zu einem Zeitsignal.

j) Identifizieren 200 von Reflexionenstellen 15-17, 25-28, 35-38 auf der Leitung in dem Zeitsignal.

k) Bestimmen 210 des Zustandes der Leitung 1 aus der Lage und Art der Reflexionsstellen 15-17, 25-28, 35-38 auf der Leitung 1 im Zeitsignal.

Es werden Iterationsschritte zur Bestimmung von Schätzwerten für alle Lücken solange durchgeführt und wiederholt, bis eine vordefinierte Anzahl an Iterationen erreicht ist, und bei jeder Iteration die Schritte h1) bis h5) ausgeführt. Es findet nach jedem Iterationsschritt eine Prüfung 186 statt, ob die vorgegebene Anzahl an Iterationen erreicht ist. Alternativ kann auch ein anderes Abbruchkriterium für die Iteration festgelegt werden, wie beispielsweise das Erreichen einer vorbestimmten minimalen Änderung eines berechneten Funktionswerts durch die aktuelle Iteration.

Einzelne Schritte des Verfahrens, beispielsweise die Schritte e) oder g), können auch an anderen geeigneten Stellen oder auch parallel ausgeführt werden. Es ist klar, dass für die jeweils durchgeführten Schritte beziehungsweise deren Operationen die jeweils benötigten Parameter zuvor bereitgestellt sein müssen.

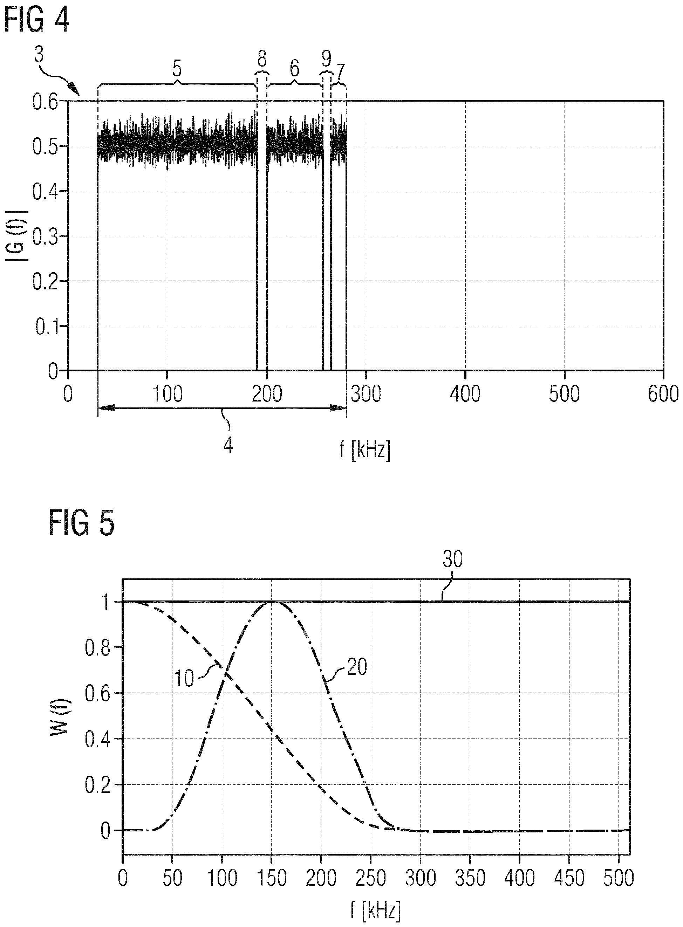

In Fig. 4 ist die Impulsantwort 3 im Frequenzbereich beispielshaft dargestellt. Die Impulsantwort 3 weist im Frequenzbereich drei Signalbereiche 5, 6, 7 und zwei Lückenbereiche 8, 9 auf. Die Lückenbereiche 8, 9 können beispielsweise durch selektives Herausfiltern von bekannten Störsignalen entstehen. Die Bandbreite 4 liegt zwischen der unteren Grenzfrequenz von 30 Hz und der oberen Grenzfrequenz von 280 kHz der Impulsantwort 3 und beträgt daher 250 kHz.

Die Impulsantwort 3 kann im Frequenzbereich in aneinandergrenzende, nicht überlappende und gleichgroße Teilbereiche unterteilt werden, welche durch jeweils durch Stützstellen beschrieben werden.

In Fig. 5 sind drei Beispiele für Fensterfunktionen 10, 20 und 30 dargestellt, welche im erfindungsgemäßen Verfahren einsetzbar sind, wie nachfolgend näher ausgeführt.

Die Auswahl der Fensterfunktion 10, 20, 30 kann anhand von Erfahrungswerten für die Messung selbst, aber auch anhand der Art der nachfolgenden Auswertung erfolgen.

Die Art der Reflexionsstellen 15-17, 25-28, 35-38 auf der Leitung 1 gibt durch den Betrag einer Phasenänderung in der Impulsantwort 3 an der Reflexionsstelle 15-17, 25-28, 35-38 den Zustand der Leitung 1 zumindest an der Reflexionsstelle 15-17, 25-28, 35-38 an.

Für eine detailreiche Auswertung, in welcher die Art von Reflexionsstellen genau analysiert werden soll, kann der Frequenzbereich inklusive 0 Hz gemäß der Fensterfunktion 10 berücksichtigt werden. Durch Bestimmung von Betrag und Phasenänderung der Reflexionsstellen ist eine genauere Untersuchung der Ursache der Reflexionsstelle möglich. Aus der Lage und Art der Reflexionsstellen auf der Leitung im Zeitsignal kann der Zustand einer Leitung bestimmt werden.

Die Fensterfunktion 10 ist eine Kosinus- oder eine Kosinus-Roll-Off-Funktion und verläuft symmetrisch um 0 Hz.

Es kann auch die Fensterfunktion 20 angewandt werden, welche den Frequenzbereich inklusive 0 Hz als auch hohe Frequenzen ausblendet. In diesem Fall kann eine Auswertung auf einfache Weise bevorzugt anhand eines Reflexions-Diagramms erfolgen.

Die Fensterfunktion 20 ist eine Kosinus- oder eine Kosinus-Roll-Off-Funktion und weist bei 0 Hz den Wert Null auf.

Die Fensterfunktion 30 kann im Fall von zyklisch gemessenen Impulsantworten oder einer ausreichend kurzen Impulsantwort angewandt werden. Die Fensterfunktion 30 ist ein konstanter Funktionswert über die Frequenz und weist einen Betrag von Eins auf. Somit kommt es zu keiner Fensterwirkung bei der Anwendung der Fensterfunktion 30. In einer äquivalenten Ausführungsform kann somit auf die Fensterfunktion gänzlich verzichtet werden und die Zusammenhänge im Verfahren vereinfachen sich entsprechend.

Die Fensterfunktion 30 ist somit eine Funktion mit konstantem Funktionswert eins.

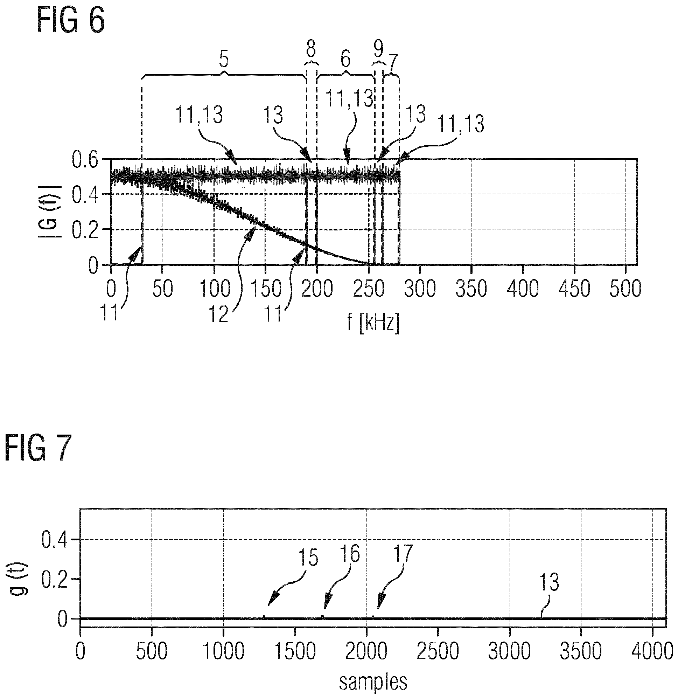

Fig. 6 zeigt verschiedene Repräsentationen im Zusammenhang mit der Impulsantwort nach Fig. 4 mit der ersten Fensterfunktion 10.

Es sind Signalbereiche 5-7 erkennbar, welche jeweilige Stützstellen aufweisen. Die Menge aller Elemente mit Stützstellen in den Signalbereichen 5-7 werden als Signale bezeichnet.

Ferner sind Lückenbereiche 8, 9 erkennbar, welche wiederum Stützstellen aufweisen. Die Menge aller Elemente mit Stützstellen in den Lückenbereichen 8, 9 wird als Lücken bezeichnet.

Die Lückenbereiche 8, 9 sind zwischen den Signalbereichen 5-7 gelegen.

Außerdem ist ein, mit der ersten Fensterfunktion 10 gefenstertes, vereinfacht dargestelltes Signal 11 im Frequenzbereich dargestellt.

Fig. 7 zeigt die nach dem erfindungsgemäßen Verfahren interpolierte Impulsantwort im Zeitbereich.

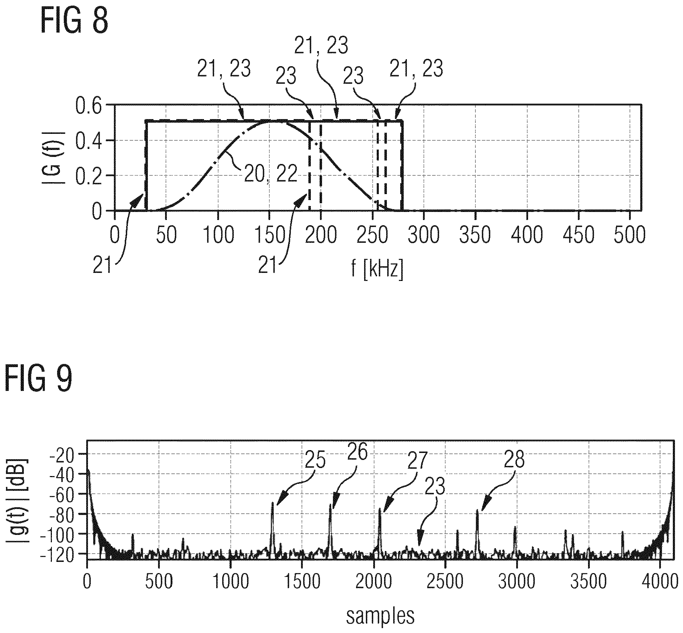

Fig. 8 zeigt verschiedene Repräsentationen im Zusammenhang mit der Impulsantwort nach Fig. 4 mit der zweiten Fensterfunktion 20, wobei die Darstellung vereinfacht ist und die Stützstellen nicht detailgetreu dargestellt sind.

Es ist somit ein vereinfacht dargestelltes Signal 21 im Frequenzbereich erkennbar. Dabei sind Signalbereiche und Lückenbereiche erkennbar, wobei aufgrund der vereinfachten Darstellung keine Stützstellen erkennbar sind.

Außerdem ist ein, mit der zweiten Fensterfunktion 20 gefenstertes, vereinfacht dargestelltes Signal 22 im Frequenzbereich dargestellt.

Ferner ist ein vereinfacht dargestelltes interpoliertes Signal 23 im Frequenzbereich erkennbar.

Fig. 9 zeigt die nach dem erfindungsgemäßen Verfahren interpolierte Impulsantwort im Zeitbereich.

Es sind Reflexionsstellen 25-28 in einem Signal 24 erkennbar. Die Art der Reflexionsstellen 25-28 auf der Leitung 1 kann den Zustand der Leitung 1 an der jeweiligen Reflexionsstelle 25-28 angeben.

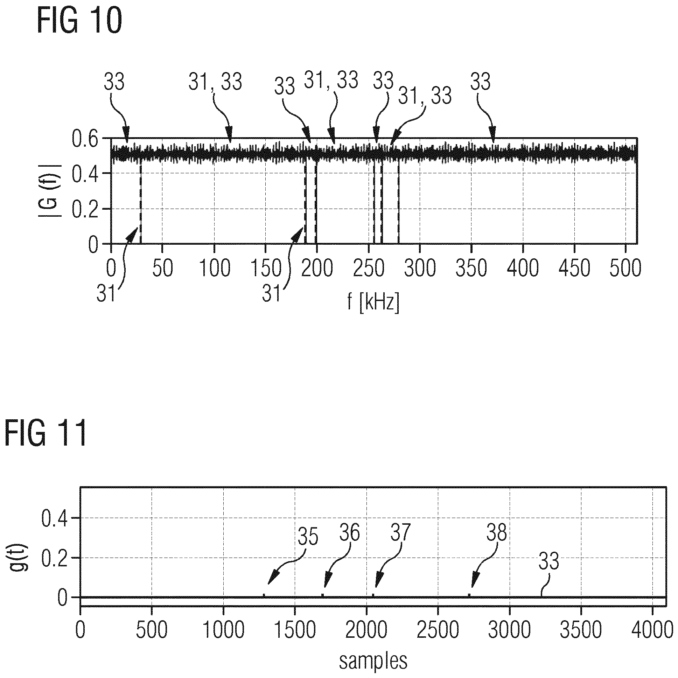

Fig. 10 zeigt verschiedene Repräsentationen im Zusammenhang mit der Impulsantwort nach Fig. 4 mit der dritten Fensterfunktion 20, welche einen konstanten Wert von eins annimmt. Mit anderen Worten hat die Fensterfunktion 30 keine Wirkung.

Es ist ein Signal 31 im Frequenzbereich erkennbar. Dabei sind Signalbereiche und Lückenbereiche mit jeweils Stützstellen erkennbar.

Ferner ist ein interpoliertes Signal 33 im Frequenzbereich erkennbar.

Fig. 11 zeigt die nach dem erfindungsgemäßen Verfahren interpolierte Impulsantwort im Zeitbereich.

Es sind Reflexionsstellen 35-38 in einem Signal 34 erkennbar. Die Art der Reflexionsstellen 35-38 auf der Leitung 1 kann den Zustand der Leitung 1 an der jeweiligen Reflexionsstelle 35-38 angeben.

**Bezugszeichenliste**

| 1 | Netzleitung |
|---|---|
| 2 | eingespeister Impuls |
| 3 | Impulsantwort |
| 4 | Bandbreite |
| 5, 6, 7 | Signalbereich |
| 8, 9 | Lückenbereich |
| 10, 20, 30 | Fensterfunktion |
| 11, 21, 31 | gemessene Impulsantwort |
| 12, 22 | Gefensterte Impulsantwort im Frequenzbereich |
| 13, 23, 33 | Interpoliertes Signal |
| 15-17, 25-28, 35-38 | Reflexionsstellen |
| 50 | Vorrichtung |
| 51 | Impulsgenerator |
| 52 | Sender |
| 53 | Empfänger |
| 54 | Analysevorrichtung |
| 100 | Verfahren |
| 110-210 | Verfahrensschritte |

**Patentansprüche**

**1.** Verfahren (100) zur Bestimmung von Reflexionen auf einer Leitung (1), umfassend folgende Schritte:

a) Erzeugen (110) eines elektrischen Impulses (2) und Einspeisen in die Leitung (1).

b) Erfassen (120) einer Impulsantwort (3) des elektrischen Impulses (2) von der Leitung (1).

c) Bilden (130) eines Impulsvektors durch Konvertieren der Impulsantwort (3) in jeweilige Elemente des Impulsvektors in Form komplexer Funktionswerte bei festgelegten Stützstellen im Frequenzbereich.

d) Zuordnen (140) der Stützstellen in Signalbereiche (5-7), an deren Stützstellen das jeweilige Element des Impulsvektors für das entsprechende Element in einen Schätzvektor übernommen wird, wobei die Menge aller Elemente mit Stützstellen in Signalbereichen (5-7) als Signale bezeichnet werden, sowie zumindest einen Lückenbereich (8, 9), an dessen zumindest einer Stützstelle ein vordefinierter Initialwert für das entsprechende Element des Schätzvektors übernommen wird, wobei die Menge aller Elemente mit Stützstellen in dem zumindest einen Lückenbereich (8, 9) als Lücken bezeichnet werden.

e) Bilden (150) eines Fenstervektors auf Basis einer Fensterfunktion (10, 20, 30) durch Diskretisieren an den Stützstellen.

f) Kopieren (160) der Elemente des Schätzvektors in einen Hilfsvektor.

g) Festlegen (170) eines ganzzahligen Koeffizienten, wobei das Verfahren **gekennzeichnet ist durch** die folgenden Schritte:

h) Durchführen (180) von Iterationsschritten zur Bestimmung von Schätzwerten für alle Lücken, und solange Wiederholen, bis eine vordefinierte Anzahl an Iterationen erreicht ist, und bei jeder Iteration folgende Schritte ausgeführt werden:

h1) Ermitteln (181) eines Zeitvektors mit Elementen im Zeitbereich auf Basis des Zusammenhangs

$$x = |iFFT(R * W)|$$

wobei

$x$ der Zeitvektor mit Elementen im Zeitbereich,
$R$ der Hilfsvektor mit Elementen im Frequenzbereich, und
$W$ der Fenstervektor mit Elementen im Frequenzbereich ist,

und der Fenstervektor und der Hilfsvektor jeweils alle Elemente an allen Stützstellen enthalten.

h2) Bestimmen (182) des Maximums der Elemente des Zeitvektors und Ermitteln eines entsprechenden Indexwerts des Maximums innerhalb der Elemente des Zeitvektors.

h3) Berechnen (183) eines Schätzwerts auf Basis des Zusammenhangs

$$Q = \frac{1}{\sum_{\forall j \in Signale} W_j} * \sum_j R_j * W_j * e^{\frac{i*2*\pi*k*j}{N}}$$

wobei

$j$ eine Indexposition,
$Q$ ein Schätzwert der aktuellen Iteration,
$R_j$ das Element des Hilfsvektors an der Indexposition,
$W_j$ das Element des Fenstervektors an der Indexposition,
$Signale$ die Menge aller Elemente an Stützstellen in Signalbereichen (5-7), und
$k$ der im Schritt h2) ermittelte Indexwert des Maximums ist, und
$N$ der im Schritt g) festgelegte ganzzahlige Koeffizient ist.

h4) Neuberechnen (184) des Hilfsvektors für die Signale auf Basis des Zusammenhangs

$$R_j = R_j - Q * e^{\frac{i*2\pi*k*j}{N}} \qquad \forall j \in Signale$$

wobei

$j$ eine Indexposition,
$R_j$ das Element des Hilfsvektors an der Indexposition,
$Q$ ein Schätzwert der aktuellen Iteration,
$k$ der im Schritt h2) ermittelte Indexwert des Maximums ist,
$Signale$ die Menge aller Elemente an Stützstellen in Signalbereichen (5-7) ist, und
$N$ der im Schritt g) festgelegte ganzzahlige Koeffizient ist.

h5) Neuberechnung (185) des Schätzvektors für die Lücken auf Basis des Zusammenhangs

$$X_j = X_j + Q * e^{\frac{i*2\pi*k*j}{N}} \qquad \forall\, j \in L\ddot{u}cken$$

wobei

$j$ eine Indexposition,
$X_j$ ein Element des Schätzvektors an der Indexposition,
$Q$ ein Schätzwert der aktuellen Iteration,
$k$ der im Schritt h2) ermittelte Indexwert des Maximums ist,
*Lücken* die Menge aller Elemente an Stützstellen im zumindest einen Lückenbereich (8, 9) ist, und
$N$ der im Schritt g) festgelegte ganzzahlige Koeffizient ist.

i) Transformieren (190) des Schätzvektors in den Zeitbereich zu einem Zeitsignal.
j) Identifizieren (200) von Reflexionenstellen (15-17, 25-28, 35-38) auf der Leitung in dem Zeitsignal.

2. Verfahren (100) nach dem vorhergehenden Anspruch, wobei im Schritt (140) d) der zumindest eine Lückenbereich (8, 9) zwischen Signalbereichen (5-7) gelegen ist.

3. Verfahren (100) nach einem den vorhergehenden Ansprüche, wobei die Impulsantwort (3) des elektrischen Impulses (2) eine Bandbreite (4) aufweist, und im Schritt (170) g) der ganzzahlige Koeffizient durch den Quotienten aus der Bandbreite (4) und dem Abstand zweier unmittelbar aneinandergrenzender Stützstellen bestimmt ist.

4. Verfahren (100) nach einem den vorhergehenden Ansprüche, wobei im Schritt (140) d) der jeweilige Initialwert zu Null gesetzt ist.

5. Verfahren (100) nach einem den vorhergehenden Ansprüche, wobei die Fensterfunktion (10, 20, 30) eine Kosinus- oder eine Kosinus-Roll-Off-Funktion ist und die Fensterfunktion (10, 20, 30) symmetrisch um 0 Hz verläuft.

6. Verfahren (100) nach einem den vorhergehenden Ansprüche, wobei die Fensterfunktion (10, 20, 30) eine Kosinus- oder eine Kosinus-Roll-Off-Funktion ist und bei 0 Hz den Wert Null aufweist.

7. Verfahren (100) nach einem den vorhergehenden Ansprüche, wobei die Fensterfunktion (10, 20, 30) eine Funktion mit konstantem Funktionswert ist, wobei vorzugsweise der Funktionswert dem Wert 1 entspricht.

8. Verfahren (100) nach einem den vorhergehenden Ansprüche, wobei ein weiterer Verfahrensschritt folgt:
k) Bestimmen (210) des Zustandes der Leitung (1) aus der Lage und Art der Reflexionsstellen (15-17, 25-28, 35-38) auf der Leitung (1) im Zeitsignal.

9. Verfahren (100) nach dem vorhergehenden Anspruch, wobei die Art der Reflexionsstellen (15-17, 25-28, 35-38) auf der Leitung (1) durch den Betrag einer Phasenänderung in der Impulsantwort (3) an der Reflexionsstelle (15-17, 25-28, 35-38) den Zustand der Leitung (1) zumindest an der Reflexionsstelle (15-17, 25-28, 35-38) angibt.

10. Vorrichtung (50) zur Bestimmung von Reflexionen auf einer Leitung (1), welche Vorrichtung (50) einen Impulsgenerator (51), einen Sender (52), einen Empfänger (53) und eine Analysevorrichtung (54) umfasst, wobei die Vorrichtung (50) dazu eingerichtet ist, durch den Impulsgenerator (51) einen Impuls (2) zu erzeugen und mittels dem Sender (52) in eine Leitung (1) einzuspeisen, sowie von dem Empfänger (53) von der Leitung (1) eine auf den Impuls (2) folgende Impulsantwort (3) zu empfangen und von der Analysevorrichtung (54) weiter zu verarbeiten, **dadurch gekennzeichnet, dass** die Analysevorrichtung (54) dazu eingerichtet ist, die Schritte c) bis j) des Verfahrens nach Anspruch 1 auszuführen und die Analysevorrichtung optional weiter dazu eingerichtet ist, das Verfahren nach einem der Ansprüche 2 bis 7 auszuführen.

11. Vorrichtung (50) nach dem vorhergehenden Anspruch, wobei die Leitung (1) eine Netzleitung eines Nieder-, Mittel- oder Hochspannungsnetzes ist und die Analysevorrichtung (54) dazu eingerichtet ist, das Verfahren nach einem der Ansprüche 8 oder 9 auszuführen und den Zustand der Netzleitung (1) zu bestimmen.

12. Vorrichtung (50) nach dem vorhergehenden Anspruch, wobei die Vorrichtung (50) von einem Smartmeter umfasst ist.

**Claims**

1. Method (100) for determining reflections on a line (1), comprising the following steps:

a) generating (110) an electrical pulse (2) and feeding it into the line (1);
b) detecting (120) a pulse response (3) of the electrical pulse (2) from the line (1);
c) forming (130) a pulse vector by converting the pulse response (3) into respective elements of the pulse vector in the form of complex function values at defined interpolation points in the frequency domain;
d) assigning (140) the interpolation points to signal ranges (5-7), at the interpolation points of which the respective element of the pulse vector is adopted for the corresponding element into an estimation vector, the set of all elements with interpolation points in signal ranges (5-7) being designated as signals, and also at least one gap range (8, 9) at the at least one interpolation point of which a predefined initial value is adopted for the corresponding element of the estimation vector, the set of all elements with interpolation points within the at least one gap range (8, 9) being designated as gaps;
e) forming (150) a window vector on the basis of a window function (10, 20, 30) by discretization at the interpolation points;
f) copying (160) the elements of the estimation vector into an auxiliary vector;
g) defining (170) an integral coefficient, wherein the method is **characterized by** the following steps:
h) carrying out (180) iteration steps for determining estimated values for all gaps, and repetition until a predefined number of iterations has been reached, and the following steps are performed during each iteration:

h1) ascertaining (181) a time vector with elements in the time domain on the basis of the relationship

$$x = \left| iFFT(R * W) \right|$$

where

$x$ is the time vector with elements in the time domain,
$R$ is the auxiliary vector with elements in the frequency domain, and
$W$ is the window vector with elements in the frequency domain,

and the window vector and the auxiliary vector each contain all the elements at all the interpolation points;
h2) determining (182) the maximum of the elements of the time vector and ascertaining a corresponding index value of the maximum within the elements of the time vector;
h3) calculating (183) an estimated value on the basis of the relationship

$$Q = \frac{1}{\sum_{\forall j \in \text{Signals}} W_j} * \sum_j R_j * W_j * e^{\frac{i * 2 * \pi * k * j}{N}}$$

where

$j$ is an index position,
$Q$ is an estimated value of the current iteration,
$R_j$ is the element of the auxiliary vector at the index position,
$W_j$ is the element of the window vector at the index position,
$Signals$ is the set of all elements at interpolation points in signal ranges (5-7), and
$k$ is the index value of the maximum ascertained in h2), and
$N$ is the integral coefficient defined in step g);

h4) recalculating (184) the auxiliary vector for the signals on the basis of the relationship

$$R_j = R_j - Q * e^{\frac{i*2\pi*k*j}{N}} \qquad \forall\, j \in \text{Signals}$$

where

$j$ is an index position,
$R_j$ is the element of the auxiliary vector at the index position,
$Q$ is an estimated value of the current iteration,
$k$ is the index value of the maximum ascertained in step h2),
*Signals* is the set of all elements at interpolation points in signal ranges (5-7),
$N$ is the integral coefficient defined in step g);

h5) recalculating (185) the estimation vector for the gaps on the basis of the relationship

$$X_j = X_j + Q * e^{\frac{i*2\pi*k*j}{N}} \qquad \forall\, j \in \text{Gaps}$$

where

$j$ is an index position,
$X_j$ is an element of the estimation vector at the index position,
$Q$ is an estimated value of the current iteration,
$k$ is the index value of the maximum ascertained in step h2),
*Gaps* is the set of all elements at interpolation points in the at least one gap range (8, 9), and
$N$ is the integral coefficient defined in step g);

i) transforming (190) the estimation vector into the time domain to form a time signal;
j) identifying (200) reflection points (15-17, 25-28, 35-38) on the line in the time signal.

2. Method (100) according to the preceding claim, wherein in step (140) d) the at least one gap range (8, 9) is located between signal ranges (5-7).

3. Method (100) according to either of the preceding claims, wherein the pulse response (3) of the electrical pulse (2) has a bandwidth (4), and in step (170) g) the integral coefficient is determined by the quotient of the bandwidth (4) and the distance between two directly adjacent interpolation points.

4. Method (100) according to any of the preceding claims, wherein in step (140) d) the respective initial value is set at zero.

5. Method (100) according to any of the preceding claims, wherein the window function (10, 20, 30) is a cosine function or a cosine roll-off function and the window function (10, 20, 30) progresses symmetrically around 0 Hz.

6. Method (100) according to any of the preceding claims, wherein the window function (10, 20, 30) is a cosine function or a cosine roll-off function and has the value zero at 0 Hz.

7. Method (100) according to any of the preceding claims, wherein the window function (10, 20, 30) is a function with a constant function value, wherein the function value preferably corresponds to the value 1.

8. Method (100) according to any of the preceding claims, wherein a further method step follows:
k) determining (210) the state of the line (1) from the position and type of the reflection points (15-17, 25-28, 35-38) on the line (1) in the time signal.

9. Method (100) according to the preceding claim, wherein the type of the reflection points (15-17, 25-28, 35-38) on the line (1) indicates the state of the line (1) at least at the reflection point (15-17, 25-28, 35-38) by way of the

**EP 3 629 036 B1**

absolute value of a phase change in the pulse response (3) at the reflection point (15-17, 25-28, 35-38) .

10. Device (50) for determining reflections on a line (1), which device (50) comprises a pulse generator (51), a transmitter (52), a receiver (53) and an analysis device (54), wherein the device (50) is configured to generate a pulse (2) by way of the pulse generator (51) and to feed it into a line (1) by means of the transmitter (52), and also to receive a pulse response (3) following the pulse (2) from the line (1) by way of the receiver (53) and to process it further by way of the analysis device (54), **characterized in that** the analysis device (54) is composed to perform steps c) to j) of the method according to Claim 1, and the analysis device is optionally further configured to perform the method according to any of Claims 2 to 7.

11. Device (50) according to the preceding claim, wherein the line (1) is a grid line of a low-, medium- or high-voltage grid and the analysis device (54) is configured to perform the method according to either of Claims 8 and 9 and to determine the state of the grid line (1).

12. Device (50) according to the preceding claim, wherein the device (50) is comprised by a smart meter.

**Revendications**

1. Procédé (100) de détermination de réflexions sur un câble (1), comprenant les étapes suivantes :

a) génération (110) et introduction d'une impulsion électrique (2) dans le câble (1),
b) détection (120) d'une impulsion réponse (3) à l'impulsion électrique (2) de la part du câble (1),
c) création (130) d'un vecteur d'impulsion par conversion de l'impulsion réponse (3) en chaque élément respectif du vecteur d'impulsion sous forme de valeurs de fonction complexe correspondant à des points de courbe déterminés dans la gamme de fréquences,
d) affectation (140) des points de courbe dans la gamme de signaux (5-7), l'élément respectif du vecteur d'impulsion étant repris pour l'élément correspondant dans un vecteur d'estimation auxdits points de courbe, la quantité de tous les éléments des points de courbe étant **caractérisée** comme des signaux dans la gamme de signaux (5-7), ainsi qu'avec au moins une zone de lacune (8, 9), une valeur initiale prédéfinie étant reprise pour l'élément correspondant du vecteur d'estimation en au moins un point de courbe de celles-ci, la quantité de tous les éléments à point de courbe étant décrite comme une lacune dans l'au moins une zone de lacune (8, 9),
e) création (150) d'un vecteur de fenêtrage à partir d'une fonction de fenêtrage (10, 20, 30) par discrétisation des points de courbe,
f) copie (160) des éléments du vecteur d'estimation dans un vecteur auxiliaire,
g) fixation (170) d'un coefficient entier tel que le procédé soit **caractérisé par** les étapes suivantes :
h) réalisation (180) d'étapes d'itération pour déterminer des valeurs estimatives pour toutes les lacunes, répétition jusqu'à atteindre un nombre prédéfini d'itérations, et réalisation des étapes suivantes à chaque itération :

h1) détermination (181) d'un vecteur temporel avec des éléments dans la gamme temporelle en fonction de l'équation

$$x = |iFFT(R * W)|$$

dans lequel

x est le vecteur temporel avec des éléments dans la gamme temporelle,
R est le vecteur auxiliaire avec des éléments dans la gamme de fréquences, et
W est le vecteur de fenêtrage avec des éléments dans la gamme de fréquences,

et le vecteur de fenêtrage et le vecteur auxiliaire contiennent respectivement tous les éléments en tous les point de courbe,
h2) détermination (182) du maximum des éléments du vecteur temporel et détermination d'une valeur d'indice correspondant au maximum parmi les éléments du vecteur temporel,
h3) calcul (183) d'une valeur estimative à partir de l'équation

$$Q = \frac{1}{\sum_{\forall j \in Signale} W_j} * \sum_{j} R_j * W_j * e^{\frac{i*2*\pi*k*j}{N}}$$

dans lequel

j est une position d'indice,
Q est une valeur estimative de l'itération actuelle,
$R_j$ est l'élément du vecteur auxiliaire au niveau de la position d'indice,
$W_j$ est l'élément du vecteur de fenêtrage au niveau de la position d'indice,
Signale est la quantité de tous les éléments aux points de courbe dans les gammes de signaux (5-7), et
k est la valeur d'indice du maximum déterminée à l'étape h2), et
N est le coefficient entier fixé à l'étape g),

h4) nouveau calcul (184) du vecteur auxiliaire pour les signaux à partir de l'équation

$$R_j = R_j - Q * e^{\frac{i*2\pi*k*j}{N}} \qquad \forall j \in Signale$$

dans lequel

j est une position d'indice,
$R_j$ est l'élément du vecteur auxiliaire au niveau de la position d'indice,
Q est une valeur estimative de l'itération actuelle,
k est la valeur d'indice du maximum déterminée à l'étape h2),
Signale est la quantité de tous les éléments aux points de courbe dans les gammes de signaux (5-7), et
N est le coefficient entier fixé à l'étape g),

h5) nouveau calcul (185) du vecteur d'estimation pour les lacunes à partir de l'équation

$$X_j = X_j + Q * e^{\frac{i*2\pi*k*j}{N}} \qquad \forall j \in L\ddot{u}cken$$

dans lequel

j est une position d'indice,
$X_j$ est l'élément du vecteur d'estimation au niveau de la position d'indice,
Q est une valeur estimative de l'itération actuelle,
k est la valeur d'indice du maximum déterminée à l'étape h2),
Lücken est la quantité de tous les éléments aux points de courbe dans l'au moins une zone de lacune (8, 9), et
N est le coefficient entier fixé à l'étape g),

i) transformation (190) du vecteur d'estimation dans la gamme temporelle en un signal temporel,
j) identification (200) de positions de réflexion (15-17, 25-28, 35-38) sur le câble dans le signal temporel.

2. Procédé (100) selon la revendication précédente dans lequel, à l'étape (140) d), l'au moins une zone de lacune (8, 9) est située entre deux gammes de signaux (5-7).

3. Procédé (100) selon l'une des revendications précédentes, dans lequel l'impulsion réponse (3) à l'impulsion électrique (2) présente une bande passante (4) et, à l'étape (170) g), le coefficient entier est déterminé par le quotient du coefficient entier par le quotient de la bande passante (4) et par l'intervalle entre deux points de courbe immédiatement contigus.

4. Procédé (100) selon l'une des revendications précédentes dans lequel, à l'étape (140) d), la valeur initiale respective est fixée à zéro.

5. Procédé (100) selon l'une des revendications précédentes, dans lequel la fonction de fenêtrage (10, 20, 30) est une fonction cosinus ou une fonction cosinus à coupure progressive, et la fonction de fenêtrage (10, 20, 30) est symétrique autour de 0 Hz.

6. Procédé (100) selon l'une des revendications précédentes, dans lequel la fonction de fenêtrage (10, 20, 30) est une fonction cosinus ou une fonction cosinus à coupure progressive, et est de valeur nulle à 0 Hz.

7. Procédé (100) selon l'une des revendications précédentes, dans lequel la fonction de fenêtrage (10, 20, 30) est une fonction de valeur constante, la valeur de la fonction étant de préférence de valeur 1.

8. Procédé (100) selon l'une des revendications précédentes, suivie d'une autre étape de procédé :
k) Détermination (210) de l'état du câble (1) sur la base de l'emplacement et du type des points de réflexion (15-17, 25-28, 35-38) sur le conducteur (1) dans le signal temporel.

9. Procédé (100) selon l'une des revendications précédentes, dans lequel le type de points de réflexion (15-17, 25-28, 35-38) sur le câble (1) indique l'état du câble (1) au moins au niveau du point de réflexion (15-17, 25-28, 35-38) par le module d'un changement de phase dans l'impulsion réponse (3) au niveau du point de réflexion (15-17, 25-28, 35-38).

10. Dispositif (50) de détermination de réflexions sur un câble (1), lequel dispositif (50) comprenant un générateur d'impulsions (51), un émetteur (52), un récepteur (53) et un dispositif d'analyse (54), le dispositif (50) étant conçu pour générer une impulsion (2) par le générateur d'impulsions (51), et pour l'introduire sur un câble (1) au moyen de l'émetteur (52) ainsi que pour recevoir du récepteur (53) du câble (1) une impulsion réponse (3) consécutive de l'impulsion (2) et pour la faire retraiter par le dispositif d'analyse (54),
**caractérisé en ce que** le dispositif d'analyse (54) est conçu de façon à réaliser les étapes c) à j) du procédé selon la revendication 1 et est, en outre, conçu pour réaliser le procédé selon l'une des revendications 2 à 7.

11. Dispositif (50) selon la revendication précédente, dans lequel le câble (1) est un câble d'un réseau basse, moyenne ou haute tension et le dispositif d'analyse (54) est conçu pour réaliser le procédé selon l'une des revendications 8 ou 9 et pour déterminer l'état du câble (1).

12. Dispositif (50) selon la revendication précédente, le dispositif (50) étant compris dans un compteur intelligent.

FIG 1

FIG 2

100

FIG 3

## FIG 4

## FIG 5

FIG 6

FIG 7

FIG 8

FIG 9

FIG 10

FIG 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2003035376 A1
- DE 102009014781 A1